# EUROPEAN PATENT APPLICATION

(11) **EP 2 346 066 A1**
(43) Date of publication of application: **20.07.2011**
(21) Application number: 09824334.8
(22) Date of filing: 21.04.2009
(51) Int. Cl.: H01L 21/00, H01L 33/00

(54) **METHOD FOR STRIPPING GaN FROM SAPPHIRE SUBSTRATE WITHOUT DAMAGE BY USING SOLID-STATE LASER**

(30) Priority: 07.11.2008 CN 200810225953
(71) Applicant: Sino Nitride Semiconductor Co, Ltd, Guangdong 523500 (CN)
(72) Inventor: ZHANG, Guoyi, Beijing 100871 (CN); SUN, Yongjian, Beijing 100871 (CN); KANG, Xiangning, Beijing 100871 (CN); CHEN, Zhizhong, Beijing 100871 (CN); YANG, Zhijian, Beijing 100871 (CN); YANG, Xinrong, Beijing 100871 (CN)
(74) Representative: Bohnenberger, Johannes
(86) International application number: PCT/CN2009/000424
(87) International publication number: WO 2010/051677

(57) **Abstract**

A method for nondestructive laser lift-off of GaN from sapphire substrates utilizing a solid-state laser is disclosed in the present invention, wherein, a solid-state laser is used as the laser source, and a small laser-spot with a circumference of 3 to 1000 micrometers and a distance of two farthest corners or a longest diameter of no more than 400 micrometers is used for laser scanning point-by-point and line-by-line, wherein the energy in the small laser-spot is distributed such that the energy in the center of the laser-spot is the strongest and is gradually reduced toward the periphery. According to the present invention, a nondestructive laser lift-off with a small laser-spot is achieved, and a scanning mode of the laser lift-off is improved, thereby a lift-off method without the need of aiming is achieved. As a result, the laser lift-off process is simplified, and the efficiency is improved while the rejection rate is reduced, such that the obstacles of the industrialization of the laser lift-off process are removed.

## Description

### TECHNICAL FIELD

The present invention relates to methods for preparations of GaN substrates and related devices by laser lift-off, more specifically to applications of solid-state lasers to separate GaN and sapphire substrate, by which a process for scanning is improved, and a method without the need of aiming is achieved, thereby preparations for GaN substrates and related devices are achieved.

### BACKGROUND OF THE INVENTION

In recent years, III/V nitrides, dominated by GaN, InGaN, and AlGaN, are receiving high attentions as semiconductor materials. Thanks to their characteristics of continuously variable direct band gap from 1.9 to 6.2 eV, excellent physical and chemical stability, and high saturation electron mobility etc., they are the most preferred materials for optoelectronic devices such as laser devices and light-emitting diodes.

However, as limited by the growth technologies of GaN itself, large area GaN materials nowadays are mostly grown on sapphire substrates. Although GaN grown on sapphire substrates has high quality and wide applications, the development of GaN based semiconductor devices is largely limited by the non electro-conductivity and poor thermal-conductivity of sapphires. In order to avoid such disadvantages, methods to replace sapphires, after growth of GaN based devices on sapphires, with substrates of Si, Cu or the like showing high thermal-conductivity and high electro-conductivity were invented. During the removal of sapphires, a mainly applied method is the laser lift-off technology.

A laser lift-off technology is a method to irradiate the GaN layer through sapphire substrates at the joint of sapphire-gallium nitride, with a laser source whose energy is less than the band gap of sapphire but larger than the band gap of GaN, as a result of the GaN here absorbing the laser energy and yielding high temperature, it is decomposed into gallium and nitrogen gas, so that a separation of GaN and sapphire substrate is achieved.

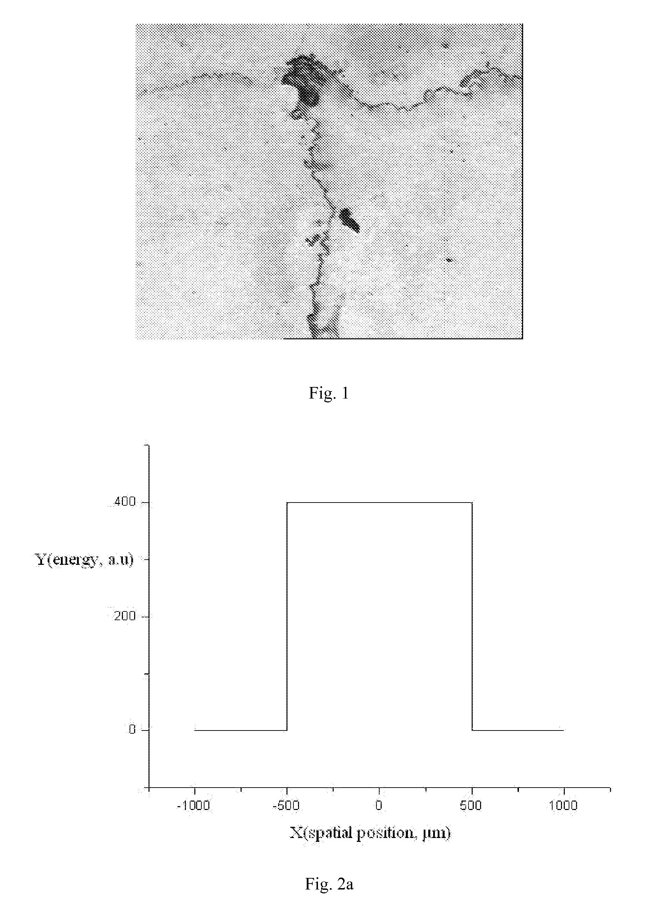

Conventional laser lift-off technologies use approaches with large laser-spot (circumference of the laser-spot is larger than 1000 micrometers), scanning chip by chip for lift-off, to achieve separation of GaN based devices and sapphire substrates. The disadvantages of such large laser-spot lift-off technologies are that, because of the large fluctuation of energy on the edge of the laser-spot, stress is highly concentrated on the edge, resulting in that GaN at the edge of the laser-spot is seriously damaged, as shown in fig. 1. The damage depth can be unequally from zero point several micrometer to several micrometers, and unavoidable. In this way, the process for laser lift-off of GaN based devices is seriously confined.

Presently, a process for making laser lift-off GaN based devices under this condition approximately are:
(1) A GaN based epitaxial wafer is grown on a sapphire;
(2) The epitaxial wafer with the sapphire substrate is made into GaN based separated device cells;
(3) Other thermal-conductive and electro-conductive substrates are electroplated or bonded;
(4) The sapphire substrate is removed by a laser lift-off method.

In the above-mentioned process, in order to avoid the large laser-spot edge damage to the GaN based devices (generally there are two types: millmeter magnitude high power devices and micrometer magnitude low power devices, with various sizes), the mostly adopted method is to directly cover a whole of one or more GaN based device cells, and to dispose the laser-spot edge in passages between GaN based device cells, so as to avoid laser-spot edge damages as much as possible.

The disadvantages of doing so are: (1) the laser-spot area has to be adjusted in accordance with the device size; (2) repeated aimings have to be done before laser scanning, to ensure that the laser-spot edge is in passages between GaN device cells; (3) a real-time video track detection is needed, in order that once a deviation arises in the scanning, it is stopped immediately for correction. The above disadvantages bring about great obstacles to large scale production applications of the laser lift-off process, and largely complicated the process, resulting in reduced efficiency and increased rejection rate (because of deviations in laser scanning processes, the edge damages are aggravated).

### DISCLOSURE OF THE INVENTION

The object of the present invention is to provide a laser lift-off method without the need of aiming, achieving a nondestructive lift-off of GaN from sapphire substrates.

The technical solution of the present invention is as follows:

A method for laser lift-off of GaN from sapphire substrates, characterized in that, a solid-state laser is used as the laser source, and a small laser-spot with a circumference of 3 to 1000 micrometers and a distance of two farthest corners or a longest diameter of no more than 400 micrometer is used for laser scanning point-by-point and line-by-line, wherein the energy in the small laser-spot is distributed such that the energy in the center of the laser-spot is the strongest and is gradually reduced toward the periphery.

According to the present invention, large laser-spot lift-off technology in prior laser lift-off methods is changed by using small laser-spot to achieve a method to lift-off GaN based device in needless of aiming. Two important reasons that the small laser-spot method has not been advanced are: (1) it is generally recognized that an edge problem will be introduced into cells of the GaN based devices by small laser-spot lift-off, so that the quality of laser lift-off will be reduced; (2) nondestructive laser lift-off by small laser-spot has not been realized yet.

A circumference of the small laser-spot used in the present invention is 3 to 1000 micrometers, and a distance of two farthest corners or a longest diameter is not more than 400 micrometers. Preferably, the circumference is 100 to 400 micrometers, and a distance of two farthest corners or a longest diameter is no more than 150 micrometers. The shape of the small laser-spot can be square, rectangle, circle, oval, pentagon, hexagon, heptagon or octagon, and so on. Such small laser-spot are for example a square laser-spot with a length of each side of 1 to 250 micrometers, or a circle laser-spot with a diameter of 1 to 400 micrometers.

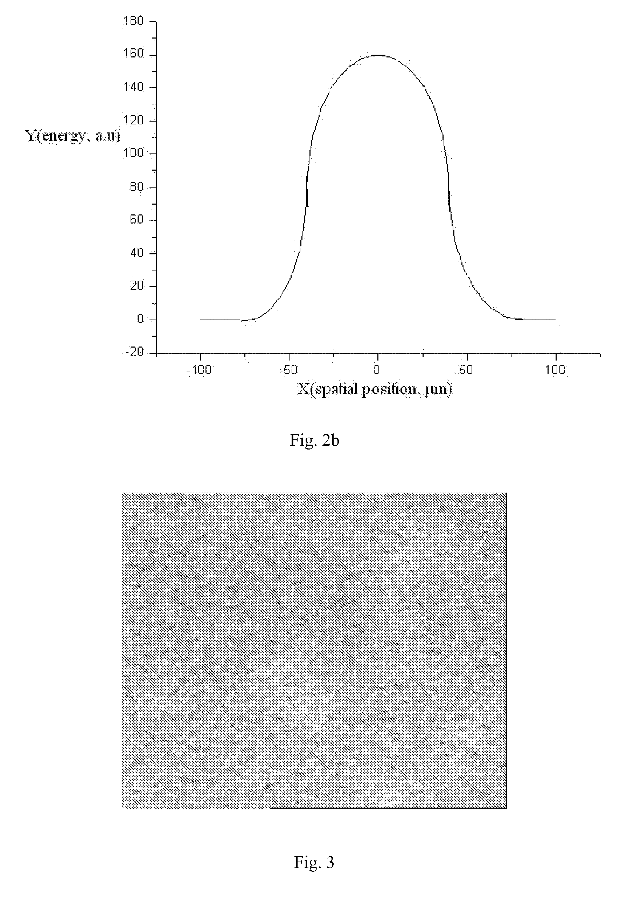

At the same time, the present invention made adjustments to the laser energy distribution of a single laser-spot, so that the prior internal laser energy fluctuation condition of the laser-spot is changed. In prior arts, energy in the large laser-spot is uniform, but with abrupt changes in the edge of the laser-spot, therefore damage is easily produced. Prior energy distribution of pulse laser-spot is shown in fig. 2a, in which the X-axis represents the side length direction of the laser-spot, and the Y-axis the energy scale, and the zero position of the X-axis corresponds to the center of the laser-spot. In the present invention, internal energy distribution condition of the laser-spot is changed and an energy uniformization is no longer pursued, while a gradual change of energy at the edge of the laser-spot is taken into consideration. The energy distribution can be as shown in fig. 2b.

Relative to the large laser-spot, the small laser-spot is easier to achieve a gradual change of laser energy of the laser-spot. It is the emphasis on the energy gradual transition (gradually changed from a stronger energy section close to the center of the laser-spot to a weaker energy section far from the center) in the edge section of the laser-spot that the stress condition of the GaN based material at the edge of the laser-spot is improved, thereby a nondestructive laser lift-off by small laser-spot is achieved.

The solid-state laser used in the present invention can be an improved solid frequency multiplier laser source, which is improved in laser fluctuation condition inside the laser-spot, that the energy is the highest in the center of the laser-spot and is gradually reduced toward the periphery, and the internal energy throughout the laser-spot represents a Gauss distribution or approximately a Gauss distribution.

According to the present invention, a nondestructive laser lift-off by small laser-spot is achieved (lift-off surface as shown in fig. 3, without apparent damage), thereby a lift-off method without aiming is achieved. According to the method of the present invention, the laser lift-off scanning mode is improved. After a step of electroplating or bonding by traditional processes, it is no longer needed to adjust the laser-spot area in accordance with the GaN device cell size, and a chip by chip scanning is not necessary. The laser scanning can be directly carried out without intermediate pauses or real time detections.

In comparison with prior arts, the advantageous effects of the present invention are:
Firstly, the laser lift-off process is largely simplified;
Secondly, the operating efficiency of laser lift-off is largely improved;
Thirdly, the rejection rate is reduced;
Fourthly, obstacles to the industrialization of the laser lift-off process are removed, and industrial production of the laser lift-off is advanced.

### DESCRIPTION OF THE DRAWINGS

Fig. 1 is a photo of the damage to laser edges left on GaN after large laser-spot laser lift-off.
Fig. 2a is a schematic diagram of the internal energy distribution of a laser-spot in prior arts; Fig. 2b is a schematic diagram of the internal energy distribution of a small laser-spot in the technical solution of the present invention.
Fig. 3 is a photo of a specimen surface after small laser-spot lift-off of the present invention.
Fig. 4 is a microscope photo magnified by 500 times of a device surface after laser lift-off of example 1 of the present invention.
Fig. 5 is a microscope photo magnified by 500 times of a device surface after laser lift-off of example 2 of the present invention.

### BEST MODE FOR CARRYING OUT THE INVENTION

The present invention is further described in details by examples in conjunction with figures, but not in any way limiting the present invention.

### Example 1

A vertical structure of a GaN based device is made by laser lift-off according to the following steps:
(1) On a sapphire, a GaN based epitaxial wafer is grown, and further made into GaN based separated device cells. Then a Cu layer is bonded on the GaN surface by Pd/In bonding method, wherein Pd is plated by sputtering to 200 nm, and In is evaporated by thermal evaporation to 600 nm. Then the Cu layer plated with Pd/In metal and the GaN wafer are bonded at a high temperature of 200 °C, and a high pressure of 1 mPa, for a duration of 20 minutes;
(2) A lift-off of the bonded specimen using an improved solid frequency multiplier laser source (YAG laser source), with a laser energy density of 600 mj/cm², a laser frequency of 20 Hz, a laser-spot size of 30 micrometers in square, and a laser-spot distance between centers of 30 micrometers, is carried out, and a point-by-point and line-by-line scanning is carried out at the sapphire surface of the specimen using the laser.

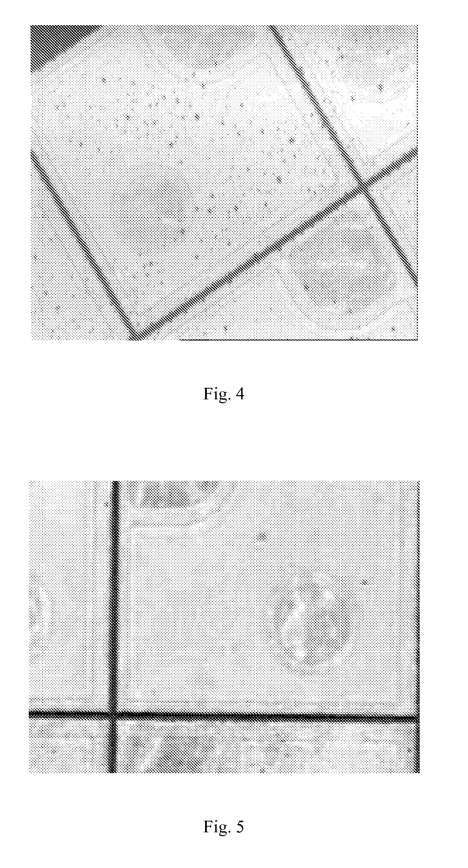

After the lift-off, the sapphire substrate is removed. The lift-off result is shown as fig. 4, which shows in a magnification of 500 times that the lift-off surface of the device is uniformly nondestructive.

### Example 2

A vertical structure of a GaN based device is made by laser lift-off according to the following steps:
(1) On a sapphire, a GaN based epitaxial wafer is grown, and further made into GaN based separated device cells. Then a Cu layer is bonded on the GaN surface by Pd/In bonding method, wherein Pd is plated by sputtering to 200 nm, and In is evaporated by thermal evaporation to 600 nm. Then the Cu layer plated with Pd/In metal and the GaN wafer are bonded at a high temperature of 200 °C, and a high pressure of 1 mPa, for a duration of 20 minutes;
(2) A lift-off of the bonded specimen using an improved solid frequency multiplier laser source (YAG laser source), with a laser energy density of 600 mj/cm², a laser frequency of 20 Hz, a laser-spot size of 100 micrometers in square, and a laser-spot distance between centers of 100 micrometers, is carried out, and a point-by-point and line-by-line scanning is carried out at the sapphire surface of the specimen using the laser.

After the lift-off, the sapphire substrate is removed. The lift-off result is shown as fig. 5, which shows in a magnification of 500 times that the lift-off surface of the device is uniformly nondestructive.

## Claims

1. A method for laser lift-off of GaN from sapphire substrates, **characterized in that**, a solid-state laser is used as the laser source, and a small laser-spot with a circumference of 3 to 1000 micrometers and a distance of two farthest corners or a longest diameter of no more than 400 micrometers is used for laser scanning point-by-point and line-by-line, wherein the energy in the small laser-spot is distributed such that the energy in the center of the laser-spot is the strongest and is gradually reduced to the periphery.

2. A method according to claim 1, **characterized in that**, a circumference of the small laser-spot is 100 to 400 micrometers, and a distance of two farthest corners or a longest diameter is not more than 150 micrometers.

3. A method according to claim 1, **characterized in that**, the shape of the small laser-spot is square, rectangle, circle, oval, pentagon, hexagon, heptagon or octagon.

4. A method according to claim 1, **characterized in that**, the solid-state laser is a solid frequency multiplier laser source.

5. A method according to claim 1, **characterized in that**, the energy throughout the small laser-spot represents a Gauss distribution or approximately a Gauss distribution, with the center of the laser-spot highest in energy.
